# EUROPEAN PATENT SPECIFICATION

(11) **EP 3 905 870 B1**
(45) Date of publication and mention of the grant of the patent: **03.01.2024**
(21) Application number: 21164559.3
(22) Date of filing: 24.03.2021
(51) Int. Cl.: H01L 23/433, H05K 7/20, G06F 1/20, H01L 23/34, H01L 23/40, H01L 23/427

(54) **HEAT TRANSPORT DEVICE AND ELECTRONIC APPARATUS**
WÄRMETRANSPORTVORRICHTUNG UND ELEKTRONISCHE EINRICHTUNG
DISPOSITIF DE TRANSPORT DE CHALEUR ET APPAREIL ÉLECTRONIQUE

(30) Priority: 28.04.2020 JP 2020078855
(43) Date of publication of application: 03.11.2021
(73) Proprietor: Lenovo (Singapore) Pte. Ltd., New Tech Park 556741 (SG)
(72) Inventor: WATANABE, Ryota, Kanagawa, 2200012 (JP); UCHINO, Akinori, Kanagawa, 2200012 (JP); YAMAZAKI, Hiroshi, Kanagawa, 2200012 (JP)
(74) Representative: Openshaw & Co.

(56) References cited:
- JP-B2- 4 799 296
- KR-A- 20190 053 589
- US-A1- 2015 205 334
- US-A1- 2017 094 831

## Description

### Field of the Invention

The present invention relates to a heat transport device which transports the heat of a heat generating element, and an electronic apparatus provided with the heat transport device.

### Background of the Invention

An electronic apparatus includes a heat generating element, such as a CPU, and heat dissipation is required, depending on the power consumption thereof. Japanese Unexamined Patent Application Publication No.2000-349479 discloses an invention in which the heat generated in a CPU is dissipated by a heat sink. The heat sink in Japanese Unexamined Patent Application Publication No.2000-349479 is a single plate which includes a heat pipe and a heat spreader and which is in contact with the upper surface of the CPU.

Meanwhile, there has been a demand for further reducing the size and the thickness of a portable electronic apparatus, such as a laptop PC and a tablet terminal. For a portable electronic apparatus, a package on package (PoP) structure could be used to miniaturize a main board. With the PoP structure, a mounting area can be reduced and a wiring length can also be shortened by, for example, stacking a logic sub-package and a memory sub-package and then mounting the stacked sub-packages on the main board.

A lower sub-package in a PoP-structure package is covered by an upper sub-package, causing the heat dissipation properties of the lower sub-package to deteriorate. Especially when the lower sub-package has a CPU that generates a large amount of heat, it is desirable to provide a certain heat transport unit. For this reason, Japanese Unexamined Patent Application Publication No.2014-116602 proposes heat dissipation by having a heat dissipation member in contact with an upper exposed surface of an electronic component in a PoP lower sub-package.

JP 4,799,296 B2 describes an electronic device comprising a housing provided with an exhaust hole. A fan blows into the exhaust hole. A first heat pipe is thermally connected to a first heating element and partially located between the fan and the exhaust hole. A second heating element is mounted on an opposite side of a circuit board to the first heating element; and a thermal connection to the second heating element is provided between the fan and the exhaust hole by a second heat pipe.

### Summary of the Invention

The invention is defined by the appended claims. Claim 1 defines a heat transport device and claim 7 defines an electronic apparatus. In the following, any method and/or apparatus referred to as embodiments but nevertheless do not fall within the scope of the appended claims are to be understood as examples helpful in understanding the invention.

According to the invention described in Japanese Unexamined Patent Application Publication No.2014-116602, the heat dissipation member is in contact with the electronic component of the lower sub-package. However, the heat dissipation member has to be interposed in a narrow gap between the lower sub-package and the upper sub-package, thus making the manufacture difficult. In addition, such a heat dissipation member cannot be retrofitted to an existing PoP structure.

When the heat sink described in Japanese Unexamined Patent Application Publication No.2000-349479 is to be applied, the heat sink is brought into contact with a surface of a heat generating element. In order to perform good heat transfer between the heat sink and the surface of the heat generating element, the contact has to be firm to a certain extent. However, excessively firm contact may damage the heat generating element.

Especially in the PoP-structure package, the lower sub-package and the upper sub-package are merely connected by solder balls, and do not necessarily have high mechanical strength. Firmly pressing the heat sink against the surface may damage the solder balls or the like due to stress.

Further, in order to perform good heat transfer between the heat generating element and the heat sink, both are desirably in surface contact with each other. However, highly accurate positioning or adjustment is required to achieve the surface-to-surface contact between the heat generating element having a small area and the heat sink having a large area.

The present invention has been made in view of the problems described above, and an object of the invention is to provide a heat transport device and an electronic apparatus which exhibit good heat dissipation properties and which do not apply stress to a heat generating element.

To solve the problems described above and to fulfill the object, a heat transport device according to the first aspect of the present invention is a heat transport device configured to transport the heat of a heat generating element mounted on a main board, including: a first heat sink which extends along a surface of the main board on which the heat generating element is mounted, and which has a sheet mounting hole formed in a portion including the heat generating element as observed in plan view; and a sheet member which is installed to the first heat sink in such a manner as to close the sheet mounting hole and which has thermal conductivity, wherein the sheet member is in thermal contact with a surface of the heat generating element and has lower rigidity than the first heat sink.

In such a heat transport device, the sheet mounting hole is formed in the first heat sink, and the low-rigidity sheet member installed to close the sheet mounting hole is in contact with the surface of the heat generating element. Consequently, external forces or vibrations attributable to the first heat sink are absorbed by the sheet member, thus protecting the heat generating element from stress. Further, the heat generated by the heat generating element is transferred to the first heat sink through the sheet member and is diffused and dissipated by the first heat sink, so that the heat transport device exhibits good heat dissipation properties.

The heat transport device includes a bracket which is fixed to the main board and which covers the sheet mounting hole; and a resin elastic member which presses the heat generating element through the sheet member while being elastically compressed by being pressed by the bracket. Thus, the resin elastic member is sandwiched between the sheet member and the bracket while being elastically compressed, causing the sheet member, which has low rigidity and can be elastically deformed, to be moderately deformed by being pressed downward by the resin elastic member so as to further securely come in close contact with the heat generating element. This further improves the heat transfer between the heat generating element and the sheet member.

The heat transport device may include: a second heat sink which extends along a back surface of the main board opposite from the surface on which the heat generating element is mounted, and which is in thermal contact at a position on the back surface that corresponds to the heat generating element; and a stud which is provided rising from the second heat sink and which passes through a through hole of the main board, wherein the bracket may be fixed to the stud.

The second heat sink may include: a first thickness portion which is in thermal contact at a position on the back surface corresponding to the heat generating element and on which the stud is provided; and a second thickness portion which is fixed to a side surface of the first thickness portion and which is thinner than the first thickness portion. The first thickness portion is thicker than the second thickness portion and is suited for the stud to be provided standing upright thereon.

If the sheet member is a graphite sheet, then the sheet member exhibits good thermal conductivity, which is effective for a case where the amount of heat generated by a heat generating element is large.

If the periphery of the sheet mounting hole is shaped to protrude toward the board, then the first heat sink is in a good thermal contact state.

Even if the heat generating element has a PoP structure, appropriate heat dissipation properties are obtained.

An electronic apparatus according to the second aspect of the present invention is an electronic apparatus provided with a heat generating element, including: a main board on which the heat generating element is mounted; a first heat sink which extends along a surface of the main board on which the heat generating element is mounted, and which has a sheet mounting hole formed in a portion including the heat generating element as observed in plan view; and a sheet member which is installed to the first heat sink in such a manner as to close the sheet mounting hole and which has thermal conductivity, wherein the sheet member is in thermal contact with a surface of the heat generating element and has lower rigidity than the heat sink.

The heat transport device and the electronic apparatus according to the above-described aspects of the present invention include the sheet member which is installed to the first heat sink in such a manner as to close the sheet mounting hole and which has thermal conductivity, and the sheet member is in thermal contact with the surface of the heat generating element and has good heat dissipation properties. Further, the sheet member has lower rigidity than the first heat sink and therefore does not apply stress to the heat generating element.

### Brief Description of the Drawings

FIG. 1 is a perspective view illustrating an electronic apparatus according to an embodiment, which is in a closed, stored state;
FIG. 2 is a perspective view schematically illustrating the electronic apparatus, which is illustrated in FIG. 1, in an opened, ready state;
FIG. 3 is a plan view schematically illustrating the internal structure of the electronic apparatus illustrated in FIG. 2;
FIG. 4 is an exploded perspective view of a chassis member and constituent components provided therein;
FIG. 5 is a perspective view of the chassis member and the constituent components provided therein;
FIG. 6 is a sectional side view of a chip having a PoP structure;
FIG. 7 is a perspective view of a bracket;
FIG. 8 is a perspective view of a sheet member; and
FIG. 9 is a sectional side view of a heat transport device.

### Detailed Description of the Invention

The following will describe in detail an embodiment of a heat transport device in accordance with the present invention with reference to the accompanying drawings. It should be noted that the present invention is not limited by the embodiment.

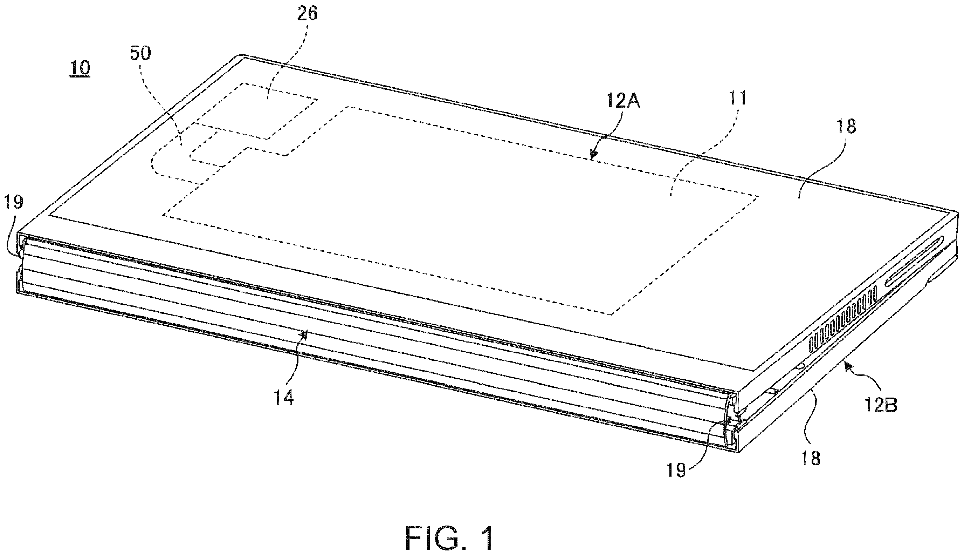

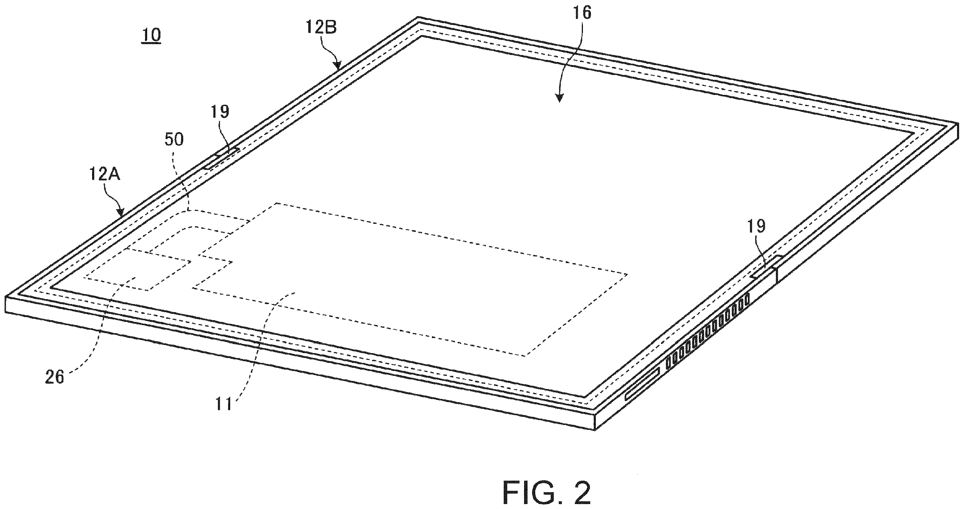

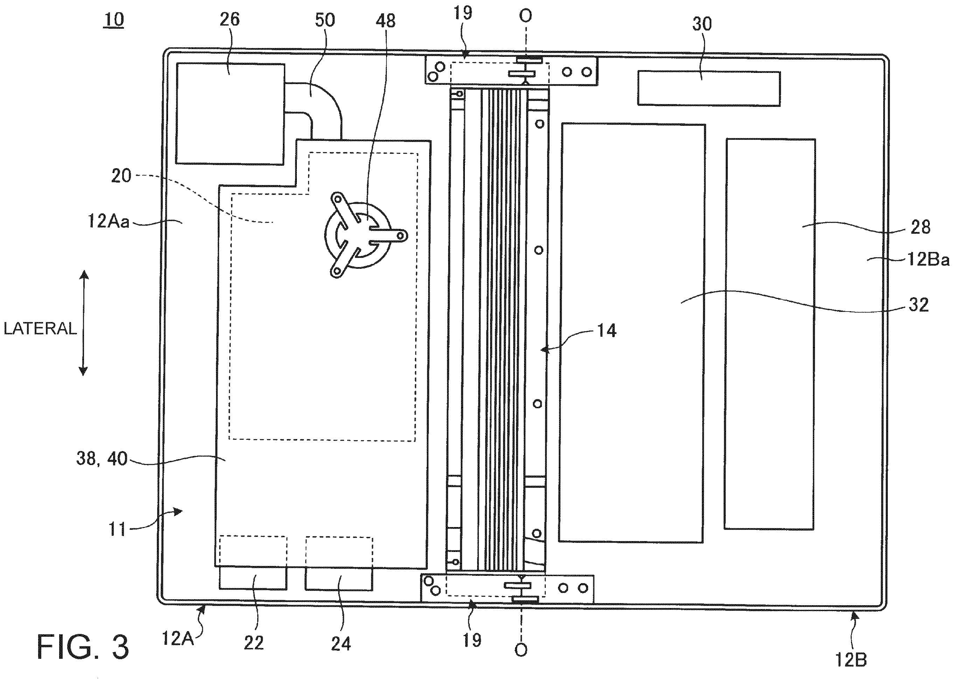

FIG. 1 is a perspective view illustrating an electronic apparatus 10 according to an embodiment of the present invention in a closed, stored state. FIG. 2 is a perspective view schematically illustrating the electronic apparatus 10, which is illustrated in FIG. 1, in an opened, ready state. FIG. 3 is a plan view schematically illustrating the internal structure of the electronic apparatus 10 illustrated in FIG. 2. The electronic apparatus 10 includes therein a heat transport device 11 according to an embodiment of the present invention.

As illustrated in FIG. 1 and FIG. 2, the electronic apparatus 10 has two chassis members 12A and 12B, a spine cover member 14, and a display 16. The chassis members 12A and 12B are covered by a cover 18. The cover 18 is made of, for example, polyurethane. The present embodiment illustrates, as the electronic apparatus 10, a tablet PC that can be folded in half like a book. The electronic apparatus 10 may be a cellular phone, a smartphone, or an electronic organizer.

The display 16 is formed of, for example, a touch panel. The display 16 has a structure that enables the display 16 to be folded together when the chassis members 12A and 12B are folded. The display 16 is, for example, a flexible display of organic electro luminescence (EL) or the like having a highly flexible paper structure, and opens and closes as the chassis members 12A and 12B are opened and closed. In other words, the electronic apparatus 10 is a so-called foldable type. The display 16 may alternatively be a liquid crystal type that does not have a foldable structure, and may be provided on either one of the chassis members 12A and 12B.

Each of the chassis members 12A and 12B is a rectangular plate-shaped member having side walls formed standing upright on three sides other than a side corresponding to the spine cover member 14. Each of the chassis members 12A and 12B is composed of, for example, a metal plate of stainless steel, magnesium or aluminum, or a fiber reinforced resin plate containing a reinforcing fiber such as carbon fiber. The display 16 is fixed to the inner surfaces of the chassis members 12A and 12B through the intermediary of a support plate. The chassis members 12A and 12B are connected through a pair of hinge mechanisms 19 and 19. The hinge mechanisms 19 connect the chassis members 12A and 12B such that the chassis members 12A and 12B can be folded as to be switched between the stored state illustrated in FIG. 1 and the ready state illustrated in FIG. 2. The line O indicated by the chain line in FIG. 3 indicates a bending center O that is the center of the folding operation of the chassis members 12A and 12B.

As illustrated in FIG. 3, the heat transport device 11, a main board 20, a communication module 22, and a solid state drive (SSD) 24, and the like are mounted on and fixed to an inner surface 12Aa of the chassis member 12A. The main board 20 and the heat transport device 11 occupy a large area in the inner surface 12Aa of the chassis member 12A. A cooling fan 26 is provided at a corner of the chassis member 12A. A sub board 28, an antenna 30, a battery unit 32, and the like are mounted on and fixed to an inner surface 12Ba of the chassis member 12B.

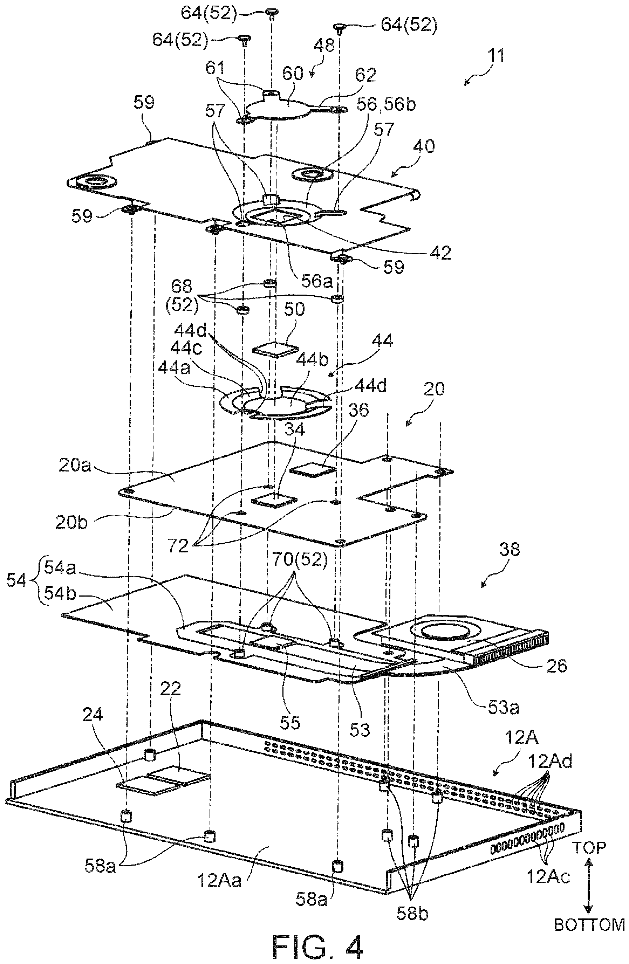

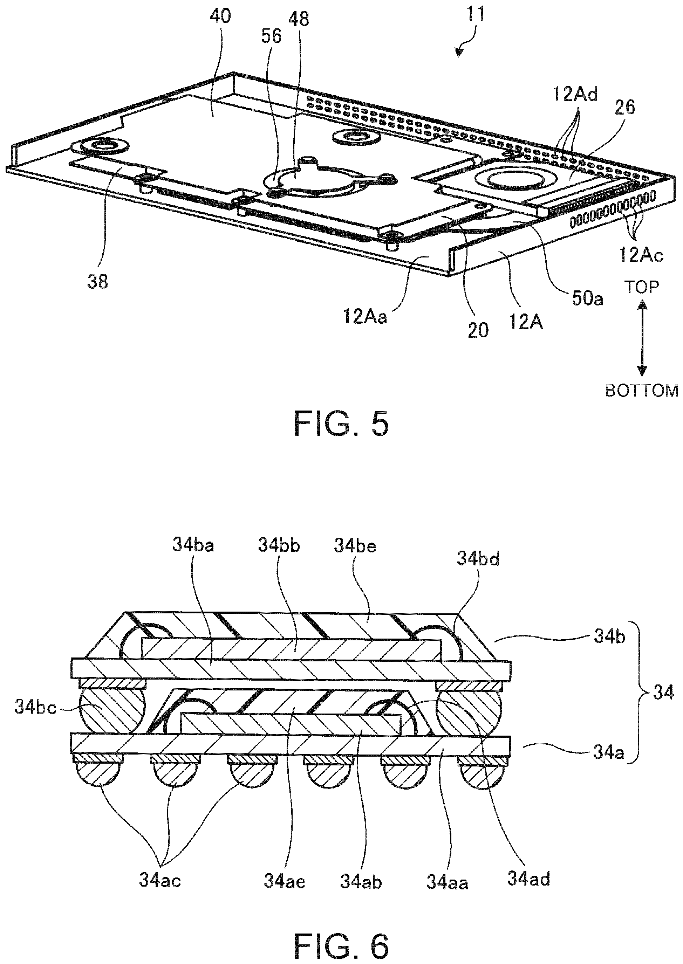

FIG. 4 is an exploded perspective view of the chassis member 12A and the constituent components provided therein. FIG. 5 is a perspective view of the chassis member 12A and the constituent components provided therein. In the following description, the direction in which the main board 20 is placed is defined as top, and the direction in which the chassis member 12A is placed is defined as bottom in FIG. 4 and FIG. 5.

As illustrated in FIG. 4 and FIG. 5, a chip 34 having a PoP structure, a chip set 36, and the like are mounted on a mounting surface 20a, which is the upper surface of the main board 20. The chip 34 is a heat generating element having a largest amount of heat among the electronic components mounted on the electronic apparatus 10. The heat transport device 11 is adapted to transport the heat of the chip 34 mounted on the main board 20; however, the heat transport device 11 can be applied also to other heat generating elements (not limited to those having the PoP structure) mounted on the main board 20.

FIG. 6 is a sectional side view of the chip 34 having the PoP structure. The chip 34 is composed of a lower sub-package 34a and an upper sub-package 34b. The gap between the lower sub-package 34a and the upper sub-package 34b is small, and the dimension of the chip 34 in the height direction is sufficiently small.

The lower sub-package 34a has a lower board 34aa and a semiconductor component 34ab. A plurality of solder balls 34ac are provided on the lower surface of the lower board 34aa, and the solder balls 34ac are electrically connected to a pattern of the main board 20. The semiconductor component 34ab is, for example, a central processing unit (CPU). The lower board 34aa and the semiconductor component 34ab are connected by a plurality of wires 34ad to perform signal transmission. The semiconductor component 34ab and the wires 34ad are sealed with a resin 34ae.

The upper sub-package 34b has an upper board 34ba and a semiconductor component 34bb. Solder balls 34bc are provided on the lower surface of the upper board 34ba, and the solder balls 34bc are electrically connected to a pattern of the lower board 34aa. The semiconductor component 34bb is, for example, a memory. The upper board 34ba and the semiconductor component 34bb are connected by a plurality of wires 34bd to perform signal transmission. The semiconductor component 34bb and wires 34bd are sealed with a resin 34be. The chip 34 is structured such that the lower sub-package 34a and the upper sub-package 34b are stacked, thus enabling the main board 20 to be made smaller. The chip 34 of the PoP structure has high mounting efficiency, and is therefore ideally used for the foldable electronic apparatus 10, which has a limited space.

Returning to FIG. 4 and FIG. 5, the heat transport device 11 has a main heat sink (a second heat sink) 38, which extends along a back surface 20b on the opposite side from the mounting surface 20a and which is in thermal contact with a position in the back surface 20b, the position corresponding to the back of the chip 34, and a sub heat sink (a first heat sink) 40, which extends along the mounting surface 20a. The designations of "main" and "sub" of the heat sinks in this case are used for ease of discrimination, and are not meant to limit the superiority or inferiority of the heat dissipation capability. The term "thermal contact" refers to contact in such a way that heat can be transferred, and includes not only direct contact, but also contact through a heat transfer element, heat transfer grease, or the like. A sub heat sink 40 has a sheet mounting hole 42 formed in a portion that includes the chip 34 as observed in plan view.

The heat transport device 11 further includes a sheet member 44 having thermal conductivity attached to the sub heat sink 40 in such a manner as to close the sheet mounting hole 42, a bracket 48 which is fixed to the main board 20 and covers the sheet mounting hole 42, and a resin elastic member 50 that presses the chip 34 through the sheet member 44 while being elastically compressed by being pressed by the bracket 48. In other words, the resin elastic member 50 is sandwiched between the sheet member 44 and the bracket 48 while being elastically compressed. The resin elastic member 50 has substantially the same shape as that of the chip 34 as observed in plan view. The resin elastic member 50 is composed of, for example, a sponge, rubber, or the like, and has elasticity. The sheet mounting hole 42 and the sheet member 44 will be described later.

The heat transport device 11 has three connection fixtures 52 which connects the sub heat sink 40 and the main heat sink 38 to the main board 20. The three connection fixtures 52 are provided around the chip 34 such that the three are located at substantially equal intervals. The connection fixtures 52 will be described in detail later.

The main heat sink 38 and the sub heat sink 40 of the heat transport device 11 are set to be larger than the main board 20 as observed in plan view. In the main board 20, many components, including the chip 34, are mounted on the mounting surface 20a, but some components may be mounted also on the back surface 20b, depending on design conditions.

The main heat sink 38 includes a heat pipe 53, which is in thermal contact with the chip 34 through the main board 20, and a heat spreader 54 which is in thermal contact with the heat pipe 53 to dissipate heat.

The heat pipe 53 is formed of, for example, a collapsed metal tube with both ends joined to form a sealed space inside, and is a heat transport device capable of transporting heat with high efficiency by utilizing the phase change of a working fluid enclosed in the sealed space. The heat pipe 53 is placed so that a part thereof is in thermal contact with the back of the chip 34 in the back surface 20b of the main board 20, and is connected in a heat transferrable manner to a cooling fan 26, an end portion 53a being connected to a blower port of the cooling fan 26. The heat pipe 53 is in thermal contact with the main board 20 through a heat transfer plate 55, but may alternatively be in direct contact with the main board 20.

The cooling fan 26 is placed in the vicinity of the end portion 53a, and takes in air from either vent holes 12Ac on one side surface of the chassis member 12A or vent holes 12Ad on the other side surface thereof, and exhausts the air to the other to release the heat of the heat pipe 53.

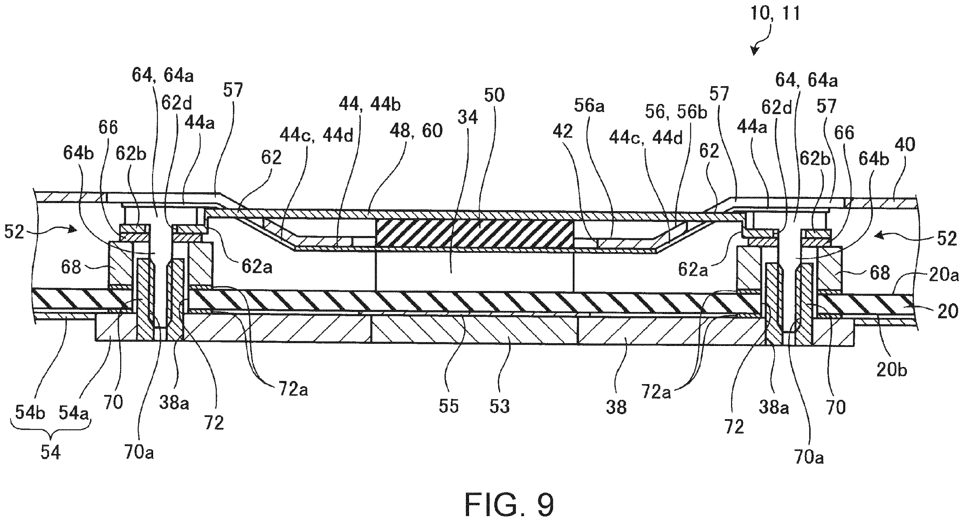

The heat spreader 54 has a first thickness portion 54a that is fixed, surrounding a portion of the heat pipe 53 except the end portion 53a, and a second thickness portion 54b that surrounds almost the entire periphery of the first thickness portion 54a and is fixed to the side surface thereof. The heat pipe 53 and the first thickness portion 54a have the same thickness (refer to FIG. 9). The second thickness portion 54b is thinner than the first thickness portion 54a (refer to FIG. 9).

The first thickness portion 54a, which is thicker than the second thickness portion 54b, can stably support the end portion 53a, which protrudes. The heat pipe 53, the first thickness portion 54a, and the second thickness portion 54b extend along the inner surface 12Aa, and do not overlap in the vertical direction. The first thickness portion 54a has an area equivalent to that of the heat pipe 53. The second thickness portion 54b has an area that is larger than the area of the first thickness portion 54a.

The heat pipe 53 and the first thickness portion 54a are fixed by, for example, pressing or press-fitting and are in contact with each other. To perform the press-fitting of the heat pipe 53 and the first thickness portion 54a, a metal pipe and a base material of the first thickness portion 54a can be, for example, simultaneously pressurized by rolling a roller thereby to collapse the metal pipe to form the heat pipe 53 and the first thickness portion 54a can be simultaneously press-fitted to the side surface of the heat pipe 53.

The first thickness portion 54a and the second thickness portion 54b are fixed and in contact with each other by, for example, pressing or press-fitting. The boundary between the first thickness portion 54a and the second thickness portion 54b may be connected by a comb-shaped meshing portion continuously provided over substantially the entire periphery. A notch is formed at a corner of the second thickness portion 54b to avoid the cooling fan 26.

The heat transfer plate 55 and the heat spreader 54 are formed of metal plates having high heat transfer properties, and are composed of, for example, aluminum, copper, stainless steel, or an alloy of these metals. The first thickness portion 54a and the second thickness portion 54b of the heat spreader 54 may be composed of the same material or different materials. Using aluminum for the first thickness portion 54a, which is thicker than the second thickness portion 54b, enables a weight reduction. Using copper for the second thickness portion 54b, which is thinner than the first thickness portion 54a, makes it possible to diffuse heat more widely due to higher heat transfer properties.

The heat pipe 53 is partly in thermal contact with the back surface 20b of the main board 20 through the heat transfer plate 55, and transfers heat to the heat spreader 54 and the cooling fan 26. The heat spreader 54 has a sufficiently large area to receive the heat from the heat pipe 53 and dissipate the heat. In addition, the cooling effect is further enhanced by the end portion 53a of the heat pipe 53 by receiving air flow from the cooling fan 26. However, depending on thermal conditions, the cooling fan 26 may be omitted.

The sub heat sink 40 is a heat spreader. For example, the same thickness and the same material as those of the second thickness portion 54b of the main heat sink 38 can be applied to the sub heat sink 40. The sub heat sink 40 has substantially the same shape as that of the main heat sink 38 as observed in plan view, and has a moderately large area. The sub heat sink 40 includes a protruding portion 56 shaped to protrude toward the main board 20. The protruding portion 56 is formed by, for example, press molding, has a gentle, substantially conical trapezoidal shape that opens upward, and includes a bottom portion 56a and a tapered portion 56b. The sheet mounting hole 42 mentioned above is formed in the bottom portion 56a, which is the lower surface of the protruding portion 56. The sheet mounting hole 42 has a rectangular shape that is slightly larger than the chip 34.

The sub heat sink 40 has three slightly lengthy arm holes 57. The arm holes 57 are the holes in which an arm 62 to be described later is inserted. The three arm holes 57 are radially provided around the protruding portion 56 at equal intervals, and partly overlap a tapered portion 56b.

The sub heat sink 40 is fixed with screws 59 to a plurality of bosses 58a provided on the inner surface 12Aa. The main board 20 is fixed with screws (not illustrated) to a plurality of bosses 58b provided on the inner surface 12Aa.

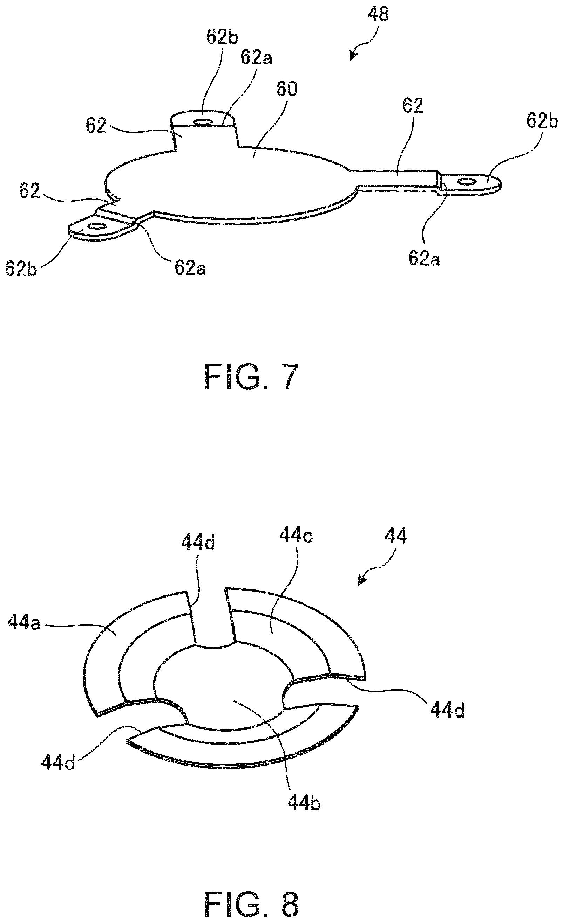

FIG. 7 is a perspective view of the bracket 48. The bracket 48 has a disc 60 and three arms 62. The bracket 48 is formed by, for example, cutting and press-molding a stainless steel plate, and has moderate rigidity while being thin. There are downward steps 62a at the middle of the arms 62, and bolt seats 62b provided at the distal ends of the arms 62 are slightly lower than the disc 60. The three arms 62 are formed radially at equal intervals.

Bolts 64 (refer to FIG. 9) are rotatably provided on the bolt seats 62b. Head portions 64a are provided on the upper surfaces of the bolt seats 62b, and male threaded portions 64b protrude downward relative to the bolt seats 62b through holes 62d (refer to FIG. 9). Washers 66 (refer to FIG. 9) are fitted onto the male threaded portions 64b to prevent falling off.

FIG. 8 is a perspective view of the sheet member 44. The sheet member 44 has a flange portion 44a on the outer periphery, a round bottom portion 44b on the inner periphery, and a tapered portion 44c connecting the flange portion 44a and the bottom portion 44b. The tapered portion 44c is shaped to protrude toward the main board 20, and is inclined so as to fit the tapered portion 56b. Three slightly deep arm notches 44d are formed in the sheet member 44. The arm notches 44d are notches into which the arms 62 are inserted. The three arm notches 44d are radially provided at equal intervals around the bottom portion 44b from the tapered portion 44c to the flange portion 44a.

FIG. 9 is a sectional side view of the heat transport device 11. FIG. 9 illustrates a section along the center of two out of the three arms 62.

As illustrated in FIG. 9, each of the connection fixtures 52 is composed of a spacer 68, a stud 70, and the bolt 64 mentioned above. The stud 70 is press-fitted and fixed to a press-fitting hole 38a provided in the first thickness portion 54a, the stud 70 being provided upright and extending upward.

Each of the studs 70 passes through a through hole 72 of the main board 20. The through hole 72 through which the stud 70 passes may be copper-plated as a part of a circuit pattern on the main board 20, or may be simply a hole without copper plating through which the stud 70 passes. If the through hole 72 is copper-plated, an insulating film may be provided on at least one of the through hole 72 and the stud 70. Ground pads 72a are provided around the through holes 72 in the mounting surface 20a and the back surface 20b.

The studs 70 are connected to the press-fitting holes 38a by, for example, serration structure, and are fixed in such a manner as to be vertically immovable and non-rotatable. The studs 70 are fixed to the first thickness portion 54a, which is thicker than the second thickness portion 54b, so that the studs 70 can be easily fixed and remain stable. Female threaded portions 70a are formed on the studs 70.

The male threaded portion 64b of the bolt 64 passes through the hollow portion of the spacer 68, and is screwed into the female threaded portion 70a of the stud 70. The spacer 68 is sandwiched between the arm 62 of the bracket 48 and the main board 20. The main board 20 is sandwiched between the spacer 68 and the main heat sink 38. With the connection fixtures 52, the bracket 48 is fixed to the main board 20 and the main heat sink 38 by the bolts 64, the spacers 66, and the studs 70. The connection fixtures 52 are not connected to the sub heat sink 40.

The arms 62 are inserted in the arm holes 57 of the sub heat sink 40 and therefore do not interfere with the sub heat sink 40. The arms 62 are fitted in the arm notches 44d of the sheet member 44 and therefore do not interfere with the sheet member 44. The tapered portion 56b of the protruding portion 56 is shaped to protrude downward, and the steps 62a of the arms 62 are downward, so that the heads 64a are positioned further below the sub heat sink 40, thus making the heat transport device 11 thinner.

The sheet member 44 is fixed to the lower surface of the sub heat sink 40. More specifically, the upper surface of the flange portion 44a of the sheet member 44 is fixed to the periphery of the protruding portion 56, the upper surface of the tapered portion 44c of the sheet member 44 is fixed to the tapered portion 56b of the protruding portion 56, and the rim of the bottom portion 44b of the sheet member 44 is fixed to the bottom portion 56a of the protruding portion 56. The sheet mounting hole 42 is formed in the bottom portion 56a of the protruding portion 56, so that the central part of the bottom portion 44b of the sheet member 44 is not fixed to the bracket 48 so as to be elastically deformable. In other words, the sheet member 44 is installed to the sub heat sink 40 in such a manner as to close the sheet mounting hole 42. The sheet member 44 and the sub heat sink 40 are fixed by bonding with, for example, a thermally conductive adhesive agent.

The sheet member 44 is thinner and less rigid than the sub heat sink 40. The sheet member 44 is manufactured separately from the sub heat sink 40, and can be manufactured to have sufficiently low rigidity without being influenced by the material, thickness, and the like of the sub heat sink 40. The sheet member 44 is, for example, approximately 0.1 mm thick. The sub heat sink 40 is, for example, approximately 0.2 mm thick.

The sheet member 44 is fixed to the sub heat sink 40 by, for example, a thermally conductive adhesive agent. The sheet member 44 is formed of, for example, a graphite sheet, copper foil, aluminum foil, or the like. The graphite sheet has good thermal conductivity, and is ideally used as a material for the sheet member 44 when the amount of heat generated by the chip 34 is large.

A place of the sheet member 44, the upper surface of which is exposed at the opening of the sheet mounting hole 42, has the lower surface thereof in thermal contact with the surface of the chip 34. The sheet member 44 and the chip 34 are bonded by, for example, a thermally conductive adhesive agent. Consequently, the heat generated by the chip 34 is transferred to the sub heat sink 40 through the sheet member 44, and is diffused and dissipated by the sub heat sink 40. Thus, the heat transport device 11 and the electronic apparatus 10 according to the present embodiment exhibit good heat dissipation properties.

The sheet member 44 is in contact with the chip 34, so that the sheet member 44 desirably has higher thermal conductivity than the sub heat sink 40, which is not in direct contact with the chip 34. A width W in the lateral direction of the chip 34 and the sheet mounting hole 42 are desirably set to be moderately small. Setting the width W to be smaller results in a larger area and a larger volume of the sub heat sink 40 accordingly, making it possible to secure heat capacity. Further, the sheet mounting hole 42 becomes smaller, and the shape of the sub heat sink 40 becomes more stable. In addition, the area occupied by the sheet member 44 can be reduced, thus providing cost reduction effect when a relatively expensive graphite sheet is used. The width W is, for example, approximately 0.5 to 2 mm, and more preferably approximately 1 mm.

The sub heat sink 40 is thicker and more rigid than the sheet member 44 and has a larger area, so that if the sub heat sink 40 were in direct contact with the chip 34 without the intermediary of the sheet member 44, then a slightly large external force could be applied to the chip 34, depending on assembly accuracy.

In contrast, in the heat transport device 11 and electronic apparatus 10 according to the present embodiment, the sheet mounting hole 42 is formed in the sub heat sink 40, and the low-rigidity sheet member 44 installed in such a manner as to close the sheet mounting hole 42 is in contact with the surface of the chip 34. Consequently, external forces and vibrations caused by the sub heat sink 40 are absorbed by the sheet member 44, suppressing forces applied to the chip 34. Therefore, stress is not applied to the chip 34, thus protecting the chip 34 and consequently eliminating the possibility of damage to, for example, the solder balls 34ac, 34bc, and the like (e.g., poor contact caused by cracks, or the like). The bottom surface of the sheet member 44 is subjected to an upward force from the chip 34, thus minimizing the possibility of coming off of the sub heat sink 40. Alternatively, however, the sheet member 44 may be fixed to the top of the sub heat sink 40, depending on design conditions.

The low rigidity of the sheet member 44 enables the sheet member 44 to elastically deform moderately within a range encompassed by the sheet mounting hole 42. Hence, even if the sub heat sink 40 is slightly inclined, the sheet member 44 elastically deforms to fit the surface of the chip 34 so as to make surface contact therebetween. This makes it possible to secure a large contact area between the chip 34 and the sheet member 44, leading to easier heat transfer.

Further, in the heat transport device 11, the resin elastic member 50 is sandwiched between the sheet member 44 and the bracket 48 by being elastically compressed. The sheet member 44 has low rigidity and is elastically deformable, so that the sheet member 44 moderately deforms by being pressed downward by the resin elastic member 50 so as to be in further close contact with the chip 34. This further improves the heat transfer between the chip 34 and the sheet member 44. The three arms 62 of the bracket 48 are provided at equal intervals, so that the bottom portion 56a and the resin elastic member 50 can be pressed in a well-balanced manner.

Meanwhile, the lower sub-package 34a (refer to FIG. 6) of the chip 34 having the PoP structure is a CPU that generates a large amount of heat, but is inferior in heat dissipation properties by itself because the lower sub-package 34a is covered by the upper sub-package 34b. Therefore, the heat transport device 11 and the electronic apparatus 10 according to the present embodiment achieve good heat dissipation properties by the main heat sink 38 and the sub heat sink 40, thus preventing the chip 34 from becoming excessively hot. More specifically, the chip 34, which is a heat generating element mounted on the main board 20, can receive and dissipate heat from the upper surface side and the lower surface side, making it possible to prevent the chip 34 from becoming excessively hot. Consequently, a component having high power consumption can be applied as the chip 34.

The protruding portion 56, which is a portion in thermal contact with the chip 34 through the sheet member 44, is shaped to protrude downward, thus making it easier for the sheet member 44 to be in contact with the chip 34 while avoiding the interference with the connection fixtures 52. Further, the sub heat sink 40 is more rigid than the sheet member 44, whereas the tapered portion 56b has some elasticity based on the shape thereof so as to make it easy for the sheet member 44 to be in surface contact with the chip 34, providing good thermal contact.

Meanwhile, the main heat sink 38 is in thermal contact with a position on the back surface 20b of the main board 20 that corresponds to the back of the chip 34 so as to receive and dissipate the heat of the chip 34 through the intermediary of the solder balls 34ac, the main board 20, and the heat transfer plate 55. The main heat sink 38 has the heat pipe 53 provided on a portion thereof adjacent to the back surface of the chip 34, and the first thickness portion 54a, which is relatively thick, is connected to the area around the heat pipe 53. In addition, the broad second thickness portion 54b is connected to the side surface of the first thickness portion 54a, thus providing high heat dissipation properties.

As described above, the heat transport device 11 and the electronic apparatus 10 according to the present embodiment include the thermally conductive sheet member 44, which is installed to the main heat sink 38 in such a manner as to close the sheet mounting hole 42, the sheet member 44 being in thermal contact with the surface of the chip 34, exhibiting good heat dissipation properties. In addition, the sheet member 44 is less rigid than the main heat sink 38, so that the sheet member 44 does not apply stress to the chip 34.

### [Description of Symbols]

- 10: electronic apparatus
- 11: heat transport device
- 20: main board (board)
- 20a: mounting surface
- 20b: back surface
- 34: chip (heat generating element)
- 34a: lower sub-package
- 34b: upper sub-package
- 38: main heat sink (second heat sink)
- 40: sub heat sink (first heat sink)
- 42: sheet mounting hole
- 44: sheet member
- 48: bracket
- 50: resin elastic member
- 52: connection fixtures
- 53: heat pipe
- 54: heat spreader
- 54a: first thickness portion
- 54b: second thickness portion
- 55: heat transfer plate
- 56: protruding portion
- 57: arm hole
- 60: disc
- 62: arm
- 68: spacer
- 70: stud
- 70a: female threaded portion
- 72: through hole

## Claims

1. A heat transport device (11) configured to transport heat of a heat generating element (34) mounted on a board (20), comprising:
a first heat sink (40) which extends along a surface of the board (20) on which the heat generating element (34) is mounted, and which has a sheet mounting hole (42) formed in a portion including the heat generating element (34) as observed in plan view; and
a sheet member (44) which is installed to the first heat sink (40) in such a manner as to close the sheet mounting hole (42) and which has thermal conductivity,
wherein the sheet member (44) is in thermal contact with a surface of the heat generating element (34) and has lower rigidity than the first heat sink (40);
wherein the heat transport device (11) further comprises:
a bracket (48) which is fixed to the board (20) and which covers the sheet mounting hole (42); and
a resin elastic member (50) which presses the heat generating element (34) through the sheet member (44) while being elastically compressed by being pressed by the bracket (48).

2. The heat transport device (11) according to claim 1, including:
a second heat sink (38) which extends along a back surface of the board (20) opposite from the surface on which the heat generating element (34) is mounted, and which is in thermal contact at a position on the back surface that corresponds to the heat generating element (34); and
a stud (70) which is provided standing upright from the second heat sink (38) and which passes through a through hole (72) of the board (20),
wherein the bracket (48) is fixed to the stud (70).

3. The heat transport device (11) according to claim 2,
wherein the second heat sink (38) includes:
a first thickness portion (54a) which is in thermal contact at a position on the back surface corresponding to the heat generating element (34), and on which the stud (70) is provided; and
a second thickness portion (54b) which is fixed to a side surface of the first thickness portion (54a) and which is thinner than the first thickness portion (54a).

4. The heat transport device (11) according to any one of claims 1 to 3,
wherein the sheet member (44) is a graphite sheet.

5. The heat transport device (11) according to any one of claims 1 to 4,
wherein a periphery of the sheet mounting hole (42) in the first heat sink (40) is shaped to protrude toward the board (20).

6. The heat transport device (11) according to any one of claims 1 to 5,
wherein the heat generating element (34) has a PoP structure.

7. An electronic apparatus (10) having a heat generating element (34), and comprising a heat transport device (11) according to any one of claims 1 to 6.

## Patentansprüche

1. Wärmetransportvorrichtung (11), die konfiguriert ist, um Wärme eines wärmeerzeugenden Elements (34) zu transportieren, das auf einer Leiterplatte (20) montiert ist, umfassend:
einen ersten Kühlkörper (40), der sich entlang einer Oberfläche der Leiterpatte (20) erstreckt, auf der das wärmeerzeugende Element (34) montiert ist, und der ein Plattenmontageloch (42) aufweist, das in einem Abschnitt ausgebildet ist, der das wärmeerzeugende Element (34) einschließt, wie in Draufsicht betrachtet; und
ein Plattenelement (44), das auf eine derartige Weise an dem ersten Kühlkörper (40) installiert ist, um das Plattenmontageloch (42) zu schließen, und das eine thermische Leitfähigkeit aufweist,
wobei das Plattenelement (44) in thermischem Kontakt mit einer Oberfläche des wärmeerzeugenden Elements (34) steht und eine geringere Steifigkeit als der erste Kühlkörper (40) aufweist;
wobei die Wärmetransportvorrichtung (11) ferner umfasst:
eine Halterung (48), die an der Leiterplatte (20) befestigt ist und das Plattenmontageloch (42) bedeckt; und
ein harzelastisches Element (50), das das wärmeerzeugende Element (34) durch das Plattenelement (44) drückt, während es elastisch komprimiert wird, indem es durch die Halterung (48) gedrückt wird.

2. Wärmetransportvorrichtung (11) nach Anspruch 1, der einschließt:
einen zweiten Kühlkörper (38), der sich entlang einer hinteren Oberfläche der Leiterplatte (20) gegenüber der Oberfläche erstreckt, auf der das wärmeerzeugende Element (34) montiert ist, und der an einer Position auf der hinteren Oberfläche in thermischem Kontakt steht, die dem wärmeerzeugenden Element (34) entspricht,; und
einen Bolzen (70), der von dem zweiten Kühlkörper (38) aufrecht stehend bereitgestellt ist und der durch ein Durchgangsloch (72) der Leiterplatte (20) hindurch verläuft,
wobei die Halterung (48) an dem Bolzen (70) befestigt ist.

3. Wärmetransportvorrichtung (11) nach Anspruch 2,
wobei der zweite Kühlkörper (38) einschließt:
einen ersten Dickenabschnitt (54a), der an einer Position auf der hinteren Oberfläche in thermischem Kontakt steht, die dem wärmeerzeugenden Element (34) entspricht, und auf dem der Bolzen (70) bereitgestellt ist; und
einen zweiten Dickenabschnitt (54b), der an einer Seitenoberfläche des ersten Dickenabschnitts (54a) befestigt ist und der dünner als der erste Dickenabschnitt (54a) ist.

4. Wärmeübertragungsvorrichtung (11) nach einem der Ansprüche 1 bis 3,
wobei das Plattenelement (44) eine Graphitplatte ist.

5. Wärmeübertragungsvorrichtung (11) nach einem der Ansprüche 1 bis 4,
wobei eine Peripherie des Plattenmontagelochs (42) in dem ersten Kühlkörper (40) geformt ist, um zu der Leiterplatte (20) hin vorzustehen.

6. Wärmeübertragungsvorrichtung (11) nach einem der Ansprüche 1 bis 5,
wobei das wärmeerzeugende Element (34) eine PoP-Struktur aufweist.

7. Elektronische Einrichtung (10), die ein wärmeerzeugendes Element (34) aufweist und umfassend eine Wärmetransportvorrichtung (11) nach einem der Ansprüche 1 bis 6.

## Revendications

1. Dispositif de transport de chaleur (11) configuré pour transporter la chaleur d'un élément générateur de chaleur (34) monté sur une carte (20), comprenant :
un premier dissipateur thermique (40) qui s'étend le long d'une surface de la carte (20) sur laquelle l'élément générateur de chaleur (34) est monté, et qui a un trou de montage de feuille (42) formé dans une partie comportant l'élément générateur de chaleur (34) tel qu'observé en vue en plan ; et
un élément de feuille (44) qui est installé sur le premier dissipateur thermique (40) de manière à fermer le trou de montage de feuille (42) et qui a une conductivité thermique,
dans lequel l'élément de feuille (44) est en contact thermique avec une surface de l'élément générateur de chaleur (34) et a une rigidité plus basse que le premier dissipateur thermique (40) ;
dans lequel le dispositif de transport de chaleur (11) comprend en outre :
un support (48) qui est fixé à la carte (20) et qui recouvre le trou de montage de feuille (42) ; et
un élément élastique en résine (50) qui presse l'élément générateur de chaleur (34) à travers l'élément de feuille (44) tout en étant comprimé élastiquement en étant pressé par le support (48).

2. Dispositif de transport de chaleur (11) selon la revendication 1, comportant :
un second dissipateur thermique (38) qui s'étend le long d'une surface arrière de la carte (20) opposée à la surface sur laquelle l'élément générateur de chaleur (34) est monté, et qui est en contact thermique au niveau d'une position sur la surface arrière qui correspond à l'élément générateur de chaleur (34) ; et
un goujon (70) qui est prévu debout à partir du second dissipateur thermique (38) et qui passe à travers un trou traversant (72) de la carte (20),
dans lequel le support (48) est fixé au goujon (70).

3. Dispositif de transport de chaleur (11) selon la revendication 2,
dans lequel le second dissipateur thermique (38) comporte :
une première partie d'épaisseur (54a) qui est en contact thermique au niveau d'une position sur la surface arrière correspondant à l'élément générateur de chaleur (34), et sur laquelle le goujon (70) est prévu ; et
une seconde partie d'épaisseur (54b) qui est fixée à une surface latérale de la première partie d'épaisseur (54a) et qui est plus mince que la première partie d'épaisseur (54a).

4. Dispositif de transport de chaleur (11) selon l'une quelconque des revendications 1 à 3,
dans lequel l'élément de feuille (44) est une feuille de graphite.

5. Dispositif de transport de chaleur (11) selon l'une quelconque des revendications 1 à 4,
dans lequel une périphérie du trou de montage de feuille (42) dans le premier dissipateur thermique (40) est façonnée pour faire saillie vers la carte (20).

6. Dispositif de transport de chaleur (11) selon l'une quelconque des revendications 1 à 5,
dans lequel l'élément générateur de chaleur (34) a une structure PoP.

7. Appareil électronique (10) ayant un élément générateur de chaleur (34), et comprenant un dispositif de transport de chaleur (11) selon l'une quelconque des revendications 1 à 6.
